# EUROPEAN PATENT SPECIFICATION

(11) **EP 1 726 046 B1**
(45) Date of publication and mention of the grant of the patent: **20.06.2007**
(21) Application number: 05733587.9
(22) Date of filing: 16.03.2005
(51) Int. Cl.: H01L 31/042, H01L 31/048

(54) **ELECTRIC ENERGY GENERATING MODULES WITH A TWO-DIMENSIONAL PROFILE AND METHOD OF FABRICATING THE SAME**
ELEKTRISCHE ENERGIEERZEUGUNGSMODULE MIT ZWEIDIMENSIONALEM PROFIL UND HERSTELLUNGSVERFAHREN DAFÜR
MODULES DE GENERATION D'ENERGIE ELECTRIQUE A PROFIL BIDIMENSIONNEL ET SON PROCEDE DE FABRICATION

(30) Priority: 16.03.2004 US 553380 P
(43) Date of publication of application: 29.11.2006
(73) Proprietor: VHF Technologies SA, 1400 Yverdon (CH)
(72) Inventor: FISCHER, Diego, CH-2000 Neuchâtel (CH); CLOSSET, Alexandre, CH-1205 Genève (CH); ZIEGLER, Yvan, 2057 Villiers (CH)
(74) Representative: P&TS Patents & Technology Surveys SA
(86) International application number: PCT/EP2005/051214
(87) International publication number: WO 2005/091379

(56) References cited:
- EP-A- 0 554 877
- EP-A- 0 874 404
- US-A- 4 860 509
- US-A- 5 998 729
- US-A1- 2001 045 228

## Description

### Field of the invention

The present invention relates to the field of electric energy generating modules, such as solar cell modules using photovoltaic films. More particularly, the present invention relates to electric energy generating modules that are especially suitable for roofing and other architectural applications having non-flat surfaces. The present invention further relates to a method of fabricating such modules.

### Description of related art

Energy harvested from solar cell technology is being increasingly exploited as a valuable, renewable and generally ubiquitous resource. The solar cell industry continues to grow as the technology employed becomes more energy efficient and more inexpensive to produce. A solar or photovoltaic (PV) cell -- the terms "solar" and "photovoltaic" are used interchangeably herein -- refers to a discrete element that converts light into electrical energy to produce a DC current and voltage. Typically, several such cells are electrically connected in series to form a PV module (also sometimes referred to as a panel) to generate energy on a larger scale. Generally, a PV module includes the solar cells and other ancillary parts, such as interconnections, contacts, structural elements, encapsulant materials, and protective devices such as diodes. The structural (i.e., load carrying) element of a module is often either a back layer substrate or a top layer superstrate. The latter must generally be transparent to transmit light to the PV cells. A number of PV modules can be further connected together to form a larger array structure.

The most common semiconductor material used in solar cells is silicon -- either in single crystal, polycrystalline, or amorphous form. In addition to the various form sof silicon, other semiconductor materials such as gallium arsenide, copper indium diselenide, and cadmium telluride are also used in solar cells. Crystalline silicon solar cells are commonly made from relatively thick (e.g., about 200 µm) silicon wafers sliced from a single crystal or polycrystalline ingot. However, more recently, it has become common for modules of much thinner solar cell films to be monolithically deposited onto low-cost substrates (such as glass or plastic) using well-known semiconductor manufacturing techniques. Such thin films provide several advantages, including easier and more cost-effective manufacturing and better suitability for mass production (although this is generally at the expense of lower efficiency). In thin-film technology, laser processing can be used in between the various deposition steps to divide a large-area substrate into individual cells, and those cells can be electrically connected to one another monolithically during the manufacturing process. Amorphous silicon, in particular, is well-suited or use in thin film solar cells. These PV cells are typically made by depositing silicon using plasma-enhanced chemical vapor deposition of a reactive gas such as silane with various dopants to form a P-I-N (or N-I-P) semiconductor structure having p-type, i-type (intrinsic), and n-type semiconductor layers.

A PV module is typically sealed or encapsulated in some manner to protect the PV elements mechanically and against corrosion. The sealing also prevents the infiltration of dust and water. The encapsulant covering the top surface of a solar cell module must be at least partly transparent to light so that at least some percentage of the desired wavelengths of light reaches the solar cells. To provide a sturdier and less fragile construction, the bottom surface of a PV module (which does not need to transmit light to the solar cells) may consist of a rigid base layer formed of aluminum or another suitable material. PV modules of this type are generally formed by laminating a thin film of solar cells between the top transparent encapsulant and the bottom base layer, as described for example in United States Patent Application No. 10/688,596, now US-A1-2004/0112425, for a "Photovoltaic Product and Process of Fabrication thereof".

Structurally rigid PV modules can also be formed by using a thick glass layer as a substrate or superstrate. Such rigid PV modules can be employed in architectural applications where the base layer is mounted to lie flat against a wall or roof surface. However, where the roof or wall does not have a flat surface (e.g., a roof with corrugated tiles), mounting the modules onto the roof requires the use of a relatively elaborate mounting configuration underneath the modules and also must ensure that the intended function of the non-flat surface (e.g., the removal of precipitation) is not compromised. Moreover, the use of flat PV modules on uneven surfaces is often detrimental to the aesthetic look of a building or other structure.

EP-A2-0874404 describes a solar cell module bent by application of a working pressure to give it the shape and rigidity required to use it in the same manner as ordinary roof material. The module comprises a photovoltaic layer with a rigid conductive substrate. Furthermore, a support member is stuck to the outside of the back surface in order to increase the mechanical strength of the module in order to realize the solar cell module which functions also as roof material. Therefore, the material of the support member must be selected among strong, rigid materials satisfying the severe requirements for roof building elements. Shaping and bending of the module is thus performed by application of a substantial pressure only, requiring an expensive press equipment. A complicated layer arrangement must be provided in order to avoid high pressures on inner layers or small radius of curvature which may damage the energy generating layer.

Furthermore, the module of EP-A2-0874404 comprises mutually connected discrete energy generating rectangular cells. The connection process is tedious and expensive; there is a need for a continuous fabrication method. In addition, different cells are bent at different places and thus exposed to different amounts of sunlight. As will be appreciated, where the cells are series-connected, the current in the resulting module is limited to the lowest current in any one cell. As a result, the efficiency of the resulting module is greatly reduced by high shading losses in some cells.

A similar solution is described in US2001/0045228. Again, the solar cell module described comprises a rigid, for example stainless steel substrate. Aluminum strain holding plates are required to give shape in the areas where there is no solar cell. Bending requires a high pressure and expensive equipment, and measures are required to prevent damage to the photovoltaic layer.

Another photovoltaic module in which a shape is given by a rigid substrate is disclosed in US-A1-2003/0140959. Forming of the substrate is obtained through mechanical constraints only.

Another photovoltaic module is disclosed by US-A-5 998 729 and teaches a module shaped into a corrugated cross section similar to that of a roof tile wherein the cells are extending perpendicular to the plane of wavy shape.

Solar cells can also be fabricated on flexible substrates, such as those made from polyimide or PET plastics, so that the resulting thin film PV module has a flexible structure. An encapsulant material such as a fluoropolymer film (e.g) may then be used to seal the entire flexible PV module without significantly detracting from the module's flexibility. One such encapsulant used in flexible PV modules is the Tefzel® film (produced by the DuPont Group of companies) applied together with ethylene vinyl acetate (EVA).

Since flexible PV films can be produced using roll-to-roll manufacturing techniques, they boast the potential for very low-cost production compared to films that must be produced using batch techniques The resulting flexible modules are also lightweight and useful in certain types of applications such as for portable PV charger modules since they can be conveniently rolled into a tubular form to occupy less space when not in use. In addition, flexible PV modules are also capable of providing much better integration with structural elementsthat are not flat. As a result, for example, flexible PV modules have been used in roofing applications by mounting the modules on top of roof tiles that do not have a generally flat surface. Because of their flexibility, the flexible modules can be made to approximately assume the profile of a non flat surface, such as corrugated or undulating roof tiles (or of a smilarly-shaped rigid base layer that is mounted onto those tiles). However, most flexible PV modules remain less durable and more fragile than their rigid counterparts making them less suitable for use in architectural applications where they are exposed to weather and/or other environmental conditions. Furthermore, the shaping and mounting of each flexible PV module so that its profile matches the desired profile of the roofing elements remains a relatively laborious process.

In view of the above, there is clearly a need for a PV module that is better suited for applications (in particular, roofing or architectural applications) where there are non-flat surfaces with a two-dimensional profile, such as corrugated roofing.

### SUMMARY OF THE INVENTION:

The present invention relates to an electric energy generating module (such as a PV module) that is particularly well-suited for mounting and integration in a location (such as the façade or roof of a building) where a non-flat physical surface is either present or desired. This is accomplished by shaping the module so that the module takes on a desired two dimensional profile to match a non-flat surface or a non-flat architectural element. The present invention further relates to a method of fabricating such an electric energy generating module. The invention also relates to a module in which the efficiency losses due to shades by profiled portions of the module on other parts of the module are reduced.

Thus, in one aspect, the present invention provides an electric energy generating module according to claim 1 comprising an electric energy generating film sealed between a top layer of encapsulant material and a bottom layer of encapsulant material. The type and quantity of the encapsulant materials are such that the shape of the encapsulant materials can be altered when at least one of a high temperature and a pressure is applied thereto, but where the encapsulant materials provide a rigid structure around the electric energy generating film under ordinary (i.e., naturally occurring) temperature and pressure conditions. Through the application of pressure and/or a high temperature, the module is shaped to have and provide a desired two dimensional profile. Thereafter, once placed under ordinary temperature and pressure conditions (such as those present outdoors) the module has a rigid structure.

The electric energy generating film comprises a plurality of strip-shaped cells electrically connected with one another. The longitudinal direction of each strip-shaped cell extends in parallel to a plane defining the two dimensional profile. Thus, shading on all serially connected strips is identical or at least comparable, and the efficiency of the module is not reduced by shading losses that arise when cells with different currents are connected in series.

In preferred embodiments, the electric energy generating film comprises a PV film (for e.g., comprising an amorphous silicon p-i-n semiconductor structure) and the top encapsulant material is at least partially transparent. The top encapsulant material is also preferably UV resistant. The bottom encapsulant material may comprise the same material as the top encapsulant material, but it may also be different.

In another aspect, the present invention provides a method of fabricating such an electric energy generating module according to claim 24. The method comprises providing an electric energy generating film, a top layer of encapsulant material and a bottom layer of encapsulant material. At least one of a high temperature and a pressure are then applied to bond the electric energy generating film, the top layer of encapsulant material and the bottom layer of encapsulant material together as a bonded stack. Furthermore, at least one of a high temperature and a pressure are also applied to shape the bonded stack to provide the module with a desired two dimensional profile. In one preferred embodiment, the bonding comprises applying a temperature of between approximately 70 and 250°C and a pressure of between approximately 0.3 to 10 bar, and the shaping comprises applying a temperature of between approximately 70 and 250°C and a pressure of between approximately 0.01 to 1 bar. The shaping may be carried out immediately following the bonding or even simultaneously with the bonding. Again, bending/shaping is performed in such a manner that the longitudinal direction of the plurality of strip-shaped cell extends in parallel to a plane defining the two dimensional profile.

### BRIEF DESCRIPTION OF THE DRAWINGS

The objects and advantages of the present invention will be better understood and more readily apparent when considered in conjunction with the following detailed description and accompanying drawings which illustrate, by way of example, preferred embodiments of the invention and in which:
Fig. 1 is an exploded view of the various layers within a PV module, prior to a bonding step, in accordance with a preferred embodiment of the present invention;
Fig. 2 is a partial cross-sectional view taken along the line II-II in Fig. 1 showing one possible structure for the PV film of Fig.1;
Fig. 3 is a high level diagram illustrating a bonding step for the PV module of Fig. 1;
Fig. 4 is a high level diagram illustrating a profiling step for shaping the PV module so that it has a desired two-dimensional profile;
Fig. 5 is a top perspective view of a profiled PV module in one embodiment;
Figs. 6A and 6B are side views of PV modules in other possible embodiments; and
Fig. 7 is an exploded view of the layers within a PV module, prior to a bonding step, in accordance with another embodiment of the present invention.

### Detailed description of preferred embodiments

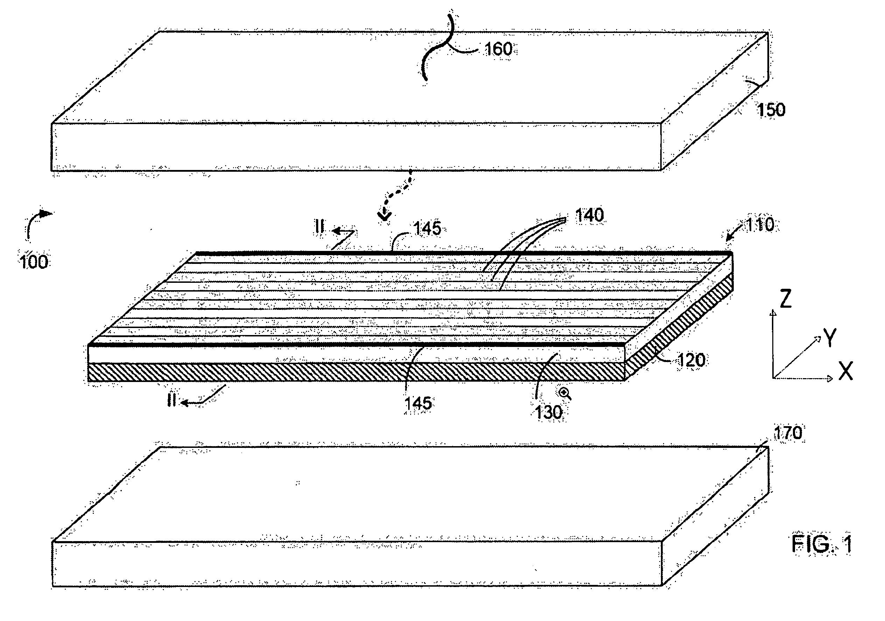

In accordance with a preferred embodiment of the present invention, Fig. 1 is an exploded view showing the different films (i.e., layers) within a PV module 100, prior to the module undergoing a bonding step. While the present invention can also be applied to other types of electrical energy generating films and modules, it is particularly suited to the PV field, and asa result PV applications are referred to herein. This is in no way intended to limit the scope of the present invention to other suitable types of electrical energy generating films and modules such as, for example, a hybrid thermophotovoltaic (TPV) film.

As shown in Rg. 1, PV module 100 is formed from a thin flexible PV film 110, a sheet of a top encapsulant material 150, and a sheet of a bottom encapsulant material 170. Although shown as flat (i.e., with a one-dimensional profile when viewed from the side), it will be appreciated that flexible PV film 110 is capable of adopting various 2-D profiles in the plane of the sheet. (In some cases, depending on the materials, structure and processes used even 3-D profiles can be adopted, though variations in the third dimension will generally be much less pronounced than in the other two dimensions.) Referring to Fig. 1, PV film 110 includes a flexible substrate 120 onto which a PV semiconductor cell structure 130 is built. Substrate 120 preferably comprises a plastic foil such as a polyimide, PET (polyethylene terephtalate), or PEN (polyethylene naphthalate) sheet. Other flexible substrates can also be used, such as aluminium, insulator-metal composites or fiber-enforced plastics. Also, in the illustrated embodiment and as will be described in more detail below, each PV cell is shaped as a strip, and a plurality of thin conductors 140 and two thicker current collection bus bars 145 run along top surface of PV cell structure 130. At least some anisotropic rigidity of the film 110 is given by the strips 130, by the conductors 140 and by the bars 145. A more important rigidity in the perpendicular direction will be given by the bending steps described below.

Top encapsulant material 150 is transparent to light 160 so that at least some percentage of the desired wavelengths of light reaches PV film 110. Preferably, top encapsulant material 150 transmits a high percentage of incident light, for example at least 90%. Top encapsulant material 150 is also preferably UV-resistant (or UV-stabilized) so that its transparency, structural reliability, and resistance to corrosion do not significantly deteriorate when exposed to UV radiation for prolonged periods. In addition, in some cases, UV radiation may cause the PV properties of the film to deteriorate, in which case it is also important for top encapsulant material 150 to block any significant amount of such radiation from reaching the film. If top encapsulant material 150 is not naturally UV resistant, it may be given these UV resistant characteristics (i.e., UV-stabilized) by using additives or protective layers that are either co-extruded or laminated onto the outer surface of material 150. Such additives or protective materials may include UV-absorbing materials or UV-stable polymers such as fluorinated polymers. Bottom encapsulant material 170 may be opaque and need not necessarily be UV-resistant or UV-stabilized; however in some embodiments it may be most expedient to simply use the same material for both the top encapsulant and bottom encapsulant.

In accordance with the present invention, both the top and bottom encapsulant materials preferably comprise a thermoformable material, such as a thermoplastic polymer, that can be softened by the application of heat and that then re-hardens on cooling. For example, materials 150 and 170 may comprise PE (polyethylene), PET (polyethylene terephtalate), PEN (polyethylene naphthalate), PC (polycarbonate), PMMA (polymethyl methacrylate), EVA (Ethylene vinyl acetate), TPU (Thermoplastic polyurethane), ETFE (Ethylene tetrafluorethylene) or various combinations of such materials Preferably, the softening temperature for the encapsulant materials 150 and 170 is between about 70 and 250°C. In another embodiment described further below, instead of (or in addition to) materials 150 and 170 being thermoformable, each of these materials may comprise an injection molding material.

For the sake of clarity, it is noted that Fig. 1 is not drawn to scale. However, the PV cell structure 130 may, for example, have a thickness of between 0.1 and 20 µm, while substrate 120 may have a thickness of between about 10 and 300 µm. For such PV films 110, the thickness of the sheets of materials 150 and 170 may correspondingly range from about 0.1 to 5 mm. It should also be noted that the thickness of the sheet of material 150 may be the same as that of material 170, but that these may also differ. Importantly, and as discussed in more detail below, the type and/or quantity of encapsulant materials 150 and 170 used in accordance with the present invention are such that the PV modules produced have a rigid and durable structure in ordinary conditions (i.e., naturally occurring temperatures and pressures), unlike the encapsulants conventionally used to seal flexible PV film products.

A thin flexible PV film may use various different materials and may have various different structures, as is well known to one of ordinary skill in the art. Generally, a PV film employs a semiconductor to absorb photons above its energy band-gap, leading to the generation of charge carriers (electrons and holes). These charge carriers are then separated by an internal electric field created by either a p-n or p-i-n junction within the semiconductor, or by a hetero-junction between the semiconductor and another material. The charge carriers are then collected by electrodes and used to generate a current in an outer circuit.

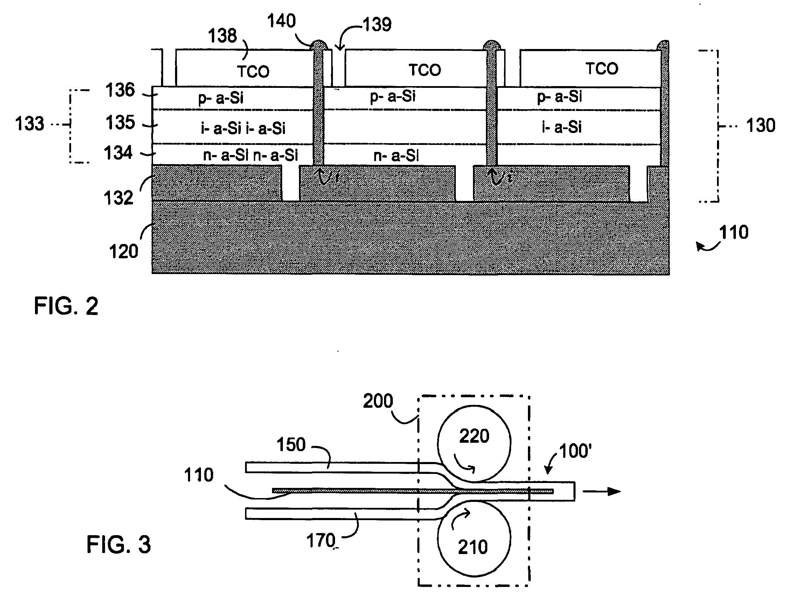

The PV modules of the present invention may generally use any type of thin PV film. In one illustrative embodiment, Fig. 2 shows a partial cross-sectional view of film 110 taken along the line II-II in Fig. 1. As shown, the PV cell structure 130 in Fig. 2 uses amorphous silicon (a-Si), deposited to form a p-i-n PV element 133 comprising p-type (p), intrinsic (i), and n-type (n) layers located between a bottom electrode 132 and a transparent top electrode 138. The fabrication of such a PV cell structure is well known and so is now only briefly described. Prior to deposition of the amorphous silicon layers, the bottom electrode layer 132 of aluminum (Al) is formed by sputtering or other suitable technique. That layer is then patterned (e.g., using a laser etching process) to separate the bottom electrodes of each cell. The n-type a-Si layer 134 is then deposited over the bottom electrode layer by PECVD from a mixture of silane and hydrogen together with a suitable dopant such as phosphine. Generally, no dopant is used during deposition of the intrinsic a-Si layer 135, while methane and diborane (or trimethylboron) may be added to the silane and hydrogen to provide the necessary doping for the subsequent p-type a-Si layer 136. Next, a transparent conductive oxide (TCO) top electrode layer 138 is deposited and then patterned to form void areas 139 to electrically isolate the top electrodes of neighboring cells. The material of top electrodes 138 should allow a high transmission of photons and suitable materials include Indium-Tin-Oxide (ITO), Tin-Oxide (SnO₂), and Zinc-Oxide (ZnO). On the other hand, bottom electrodes 132 may comprise any conductive material be it opaque (e.g., aluminum or silver) or a TCO as described above.

The above-described steps may be carried out using the single chamber roll-to-roll apparatus and method described in United States Patent Application Publication No. 2003/0172873A1 by Fischer et al., the entire contents of which are incorporated herein by virtue of this reference. In addition, to provide a series connection between the parallel individual strip-shaped PV cells, a mechanical (or laser) scribe is used to etch a current-carrying grid pattern through the layers 138, 136, 135, 134, and (partially) 132. The etched areas are then filled with a conductive paste (e.g., a silver paste) to create thin conductors 140. In this manner, an electrical series connection is provided between the top electrode 138 and the bottom electrode 132 of neighboring cells.

It will also be appreciated that apart from a single-junction p-i-n a-Si PV cell structure, higher efficiency solar cell structures can be created using stacked tandem (p-i-n/p-i-n) or triple (p-i-n/p-i-n/p-i-n) junctions, or using cells that include a thicker i-type layer of microcrystalline silicon which may also be deposited by a PECVD process. Furthermore, as already noted above, flexible thin PV films may also be based on other semiconductor materials such as polycrystalline silicon, microcrystalline silicon, thin film silicon, thin film tandem cells, copper indium gallium diselenide (CIGS), CIS elements, cadmium telluride (CdTe), nano-crystalline dye-sensitized materials, or conductive polymers. It will be appreciated that the semiconductor structure will generally differ depending on the material used.

Referring now to Fig. 3, a lamination step for bonding thin flexible PV film 110 with the sheets of top encapsulant material 150 and bottom encapsulant material 170 is illustrated. Sheet 150, film 110, and sheet 170 are fed into a laminator 200 or other suitable device capable of bonding together the three sheets under a high temperature. In the illustrated embodiment, laminator 200 is a hot roll press with two rotating drums 210 and 220 that apply pressure at a temperature of between about 70 and 250°C to bond the sheets together and provide a bonded PV module stack 100'. In a preferred embodiment, the pressure applied by laminator 200 is from between about 0.3 bar to 10 bar (1 bar = 100 kPa), and in one specific example a pressure of 1 bar is used. The bonding process may exploit the self-adhesive properties of encapsulant materials 150 and 170, or additional layers of adhesive material (not shown), such as glue, silicon, or ethylene vinyl acetate, may be interposed between PV film 110 and each encapsulant sheet. Although laminator 200 applies the combination of both a pressure and a high temperature, in some embodiments only/primarily pressure or only/primarily high temperature can be used to effect the bonding, although the effectiveness of such techniques will generally depend on the type of encapsulant materials 150 and 170 being used. It will nevertheless be appreciated that whatever combination of temperature and pressure are applied, the imposed conditions will not be conditions that occur naturally, i.e., a combination of temperature and/or pressure that module 100 would otherwise be exposed to.

The bonding step may occur in a variety of different manners. In one embodiment, the bonding step occurs as an entirely batch process using a flat press that bonds together individual flat sections of film 110, top encapsulant 150, and bottom encapsulant 170 to form the bonded stack 100' for a single PV module (preferably so that an overlap of encapsulant surrounds the PV film on all sides). This technique may be preferred if an adhesive layer (such as an EVA layer) is also used to help create the bonded stack 100'. Alternatively, a roll batch process may be used in which sheets of film 110, top encapsulant 150, and bottom encapsulant 170 are fed into a roll press (such as laminator 200 in Fig. 3) from three individual rolls. As another alternative, continuous films corresponding to a plurality of PV modules of film 110, top encapsulant 150, and bottom encapsulant 170 may be fed into a roll press from three individual rolls, and cut to the desired length after lamination or after shaping.

It is preferred that the encapsulant materials overlap each side of the PV film to provide edge sealing, and this is possible using either of the first two techniques described above. However, for the continuous filmsin the third technique, when the continuous laminated material is cut, the PV film will be exposed at the cut edge and therefore will be susceptible to infiltration and/or degradation. In this case, an additional step to seal the cut edge may be carried out by reheating the severed bonded stack and welding the existing thermoplastic materials in the stack around the exposed edge to seal it. If necessary or desired, additional thermoformable material can also be added to the bonded stack when sealing the cut/exposed edge.

In some embodiments, it may also be desirable to carry out the bonding step in a vacuum to help prevent any air being incorporated into the sealed bonded stack 100'. Furthermore, while the top surface of a bonded PV module stack 100' may be simply flat, that surface may also be textured in a manner that alters reflection properties, avoids glare, improves light trapping, and/or improves the aesthetic look of the module. This texture may be applied by using a suitable surface structure on the lamination press/rolls used to bond together the layers.

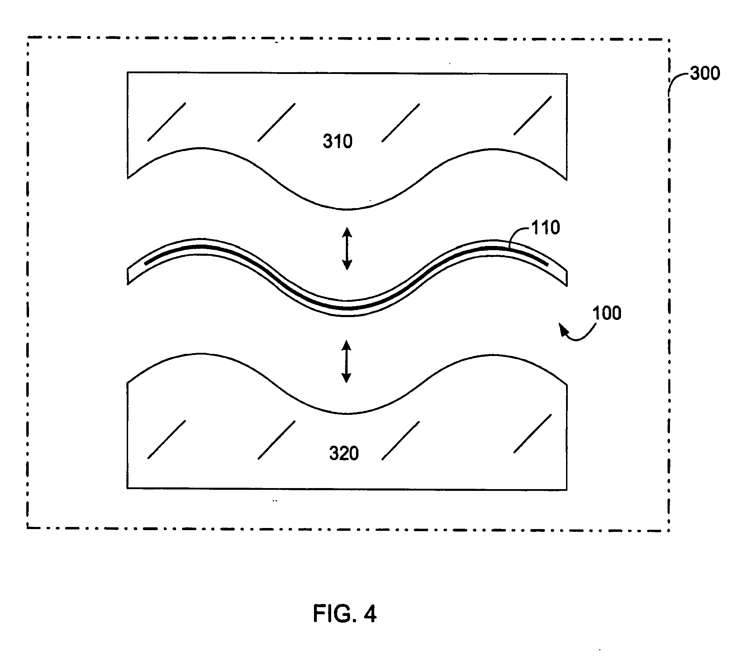

In accordance with the present invention, after the different sheets of the PV module have been bonded together, the bonded stack 100' is further shaped by the application of pressure (preferably together with a high temperature) to provide a PV module 100 with a desired two-dimensional profile (i.e., a two-dimensional outline as seen from the side). In the illustrated embodiment of Fig. 4, a profiling device 300 includes complementary mold sections 310 and 320 operating at a high temperature to mechanically force module 100 into a desired profile shape. In a preferred embodiment, the pressure applied by device 300 varies from about 0.01 to 1 bar, and in one specific embodiment the pressure applied is 0.05 bar. The temperature in device 300 corresponds to the softening temperatures of the thermoformable encapsulant materials 150 and 170, which as noted above may be from between 70 and 250°C. In alternative embodiments, the profiling step may be carried out by fixing the bonded stack 100' in the frame of a molding device, heating the stack, and then applying a vacuum through holes in two complementary mold sections so that air pressure compresses the mold sections against the bonded stack 100' so that the latter takes on the shape of those mold sections.

Like the bonding step, the profiling step may be carried out as a batch process (as illustrated), or a continuous roll process may be used. Furthermore, the profiling step may be carried out immediately after the bonding step, possibly within the same device (i.e., laminator 200 and profiling device 300 may be combined), since the bonded PV module stack 100' generally does not require cooling prior to undergoing the profiling step. As a further alternative, both the bonding and the profiling step may occur at the same time, as single process step. The above approaches are preferred if encapsulant materials 150 and 170 comprise a thermoplastic polymer that degrades chemically when repeatedly heated and cooled or especially if encapsulant materials 150 and 170 comprise a thermosetting material which can only be heated and cured once.

As another alternative, instead of bonding and profiling as described above, a profiled PV module 100 can be realized using injection molding techniques. In this case, PV film 110 is placed in a profiled injection mold (not shown), and an encapsulant resin material (with the transparency and UV resistant properties mentioned above) is injected to embed the module in the desired profile shape. Suitable examples of injection molding encapsulants include PET (polyethylene terephtalate), PC (polycarbonate), PP (polypropylene), PA (polyamide), ABS(acrylonitrile / butadiene / styrene) or various combinations of such materials

Re-hardening of the encapsulant material after shaping is preferably performed by cooling, or letting the module return to ambient temperature condition. However, depending on the materials used, hardening may be improved, initiated or accelerated using chemical agentsor ultra-violet light for example.

Once the profiling step has completed and PV module 100 has cooled, a rigid, strong, durable and still relatively lightweight PV module is provided even though no rigid plate or support member (such as aluminum or glass base) forms part of the module. As will be appreciated, it is an important aspect of the present invention that the type and quantity of encapsulant materials used are sufficient to provide PV module 100 with such a rigid and durable structure once the module has cooled and is used under ordinary conditions (i.e., naturally occurring temperatures and pressures). This differs from the encapsulation of existing thin film flexible PV modules where the type and/or quantity of encapsulant used allow the modules to retain their flexible nature under ordinary conditions. In one exemplary embodiment of the present invention, the overall thickness of PV module 100 is about 2 mm which provides a strong, rigid, and yet lightweight structure.

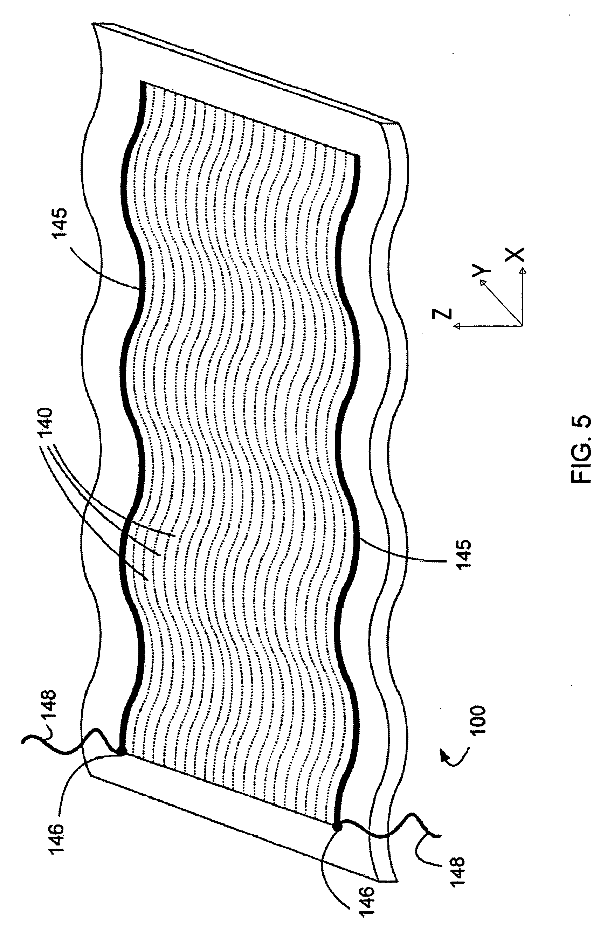

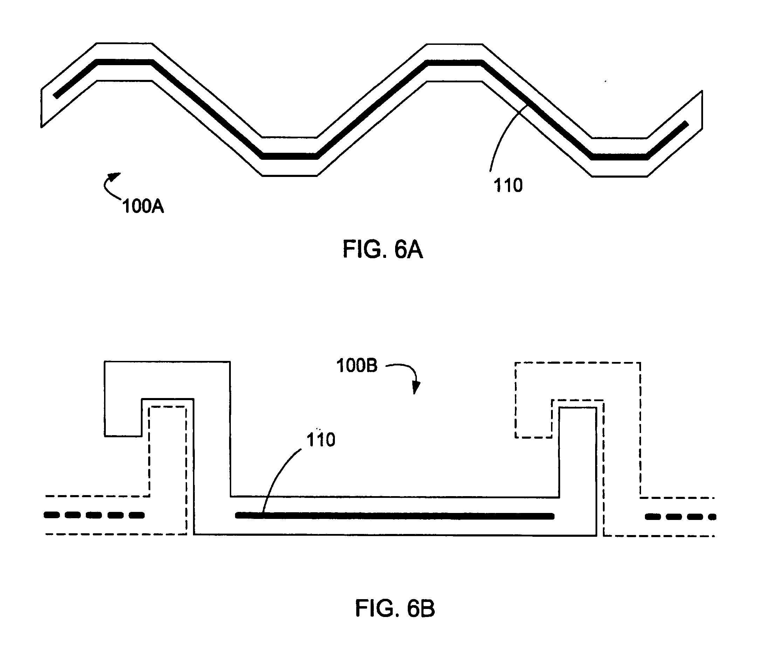

The shape of the profile of PV module 100 can be corrugated (i.e., with alternating ridges and grooves), standing seam (i.e., interlocking), or any other desired non-flat (i.e., 2-D profile) shape required for a given application. In the embodiment of Fig. 4, PV module 100 is corrugated with an approximately sinusoidal profile. A more detailed top perspective view of such a PV module is shown in Fig. 5. Alternate PV module profiles are also exemplarily shown in Figs. 6A and 6B. More specifically, Fig. 6A shows a side view of a PV corrugated module 100A with a corrugated trapezoidal profile, while Fig. 6B shows a side view of a PV corrugated module 100B with a profile suitable for providing a standing seam effect so that neighboring PV modules can interlock with one another. As shown, in the specific embodiment of Fig. 6B, even though PV module 100B has a 2-D profile, the profile of PV film 110 inside module 100B is nonetheless flat (i.e., film 110 has a 1-D profile) in this case.

Typically, the top and bottom surfaces of the PV modules are otherwise uniform, in that a cross-section of the module in a plane parallel to that of the 2-D profile will share the same 2-D profile. However, this is not necessary and may not be the case where sections acting as fixing points, border sections, or for making electrical contacts are included in the PV module.

Furthermore, a three-dimensonal texture may be provided in the top-encapsulant layer, for example by using mold sections 310 and possibly 320 with a textured surface. The texture may define micro-optical elements, for example micro-lenses, for improving convergence of light onto photovoltaic active portions of the film 110 and for deviating light away from the non-active portions of the film (such as the interconnection areas 139 and 140 and areas covered with additional current collecting finger grids). In addition or alternatively, the texture may improve the optical appearance of the module, and/or might reduce unwanted glare of the module surface.

As will be appreciated, where the PV cells in PV module 100 are series-connected, the current in the PV module is limited to the lowest current in any one PV cell. As a result, as shown in Fig. 5, the longitudinal axis x1 of the strip-shaped cells and the thin conductors 140 that monolithically provide the electrical series connections between neighboring cells are preferably oriented in parallel to a plane x;z defining the 2-D profile of the module (i.e., the plane of the drawing). This ensures that no PV cell is located entirely (or predominantly) along a groove or valley within the 2-D profile where the cell may be exposed to only minimal sunlight which would significantly limit the current conducted through the PV module as a whole. Instead, with the cell orientation of Fig. 5, no shading losses occur (other than pure geometrical losses) since each cell will generally be exposed to the same amount of sunlight and therefore generate the same amount of current. Serial-connection of the strips will thus be possible without reducing the resulting current over the cells.

Similarly, although the cell orientation is not shown in Figs 6A and 6B, where the cells and series-connections for modules 100A and 100B are strip shaped, these again are preferably oriented in parallel to a plane defining the 2-D profile of the module. Of course, if the PV cells in module 100 are electrically connected in a different manner, a different cell orientation may be preferable.

As also shown in Fig. 5, PV module 100 may have two contact openings 146 formed through the encapsulant material to connect electrical wires 148 to each current collection bus bar 145 in PV film 110. For illustration purposes, contact openings 146 are shown as having been made through the top surface of PV module 100 in Fig. 5. However, more typically, the contact portions will be formed via an opening formed through the encapsulant from the bottom surface of the module. Contact openings 146 are preferably formed after the bonding and profiling steps are complete, in the manner described in United States Patent Application 10/688,596 for a "Photovoltaic Product and Process of Fabrication thereof" now US-A1-2004/0112425. Once the necessary connections have been made, openings 146 may be sealed for protection purposes As will be appreciated, by connecting wires 148 to PV module 100 the module may be connected with other PV modules as part of a PV array and/or to an external electrical circuit. Alternatively, instead of attaching wires 148, openings 146 may simply enable electrical connection of PV module 100 directly to an underlying PV junction box.

As noted, after they have been shaped, the PV modules are rigid, strong, and durable. As a result, the modules are better able to with stand exposure to adverse weather and other environmental conditions compared to most conventional flexible PV film products. At the same time, by taking on a desired 2-D profile shape, the PV modules of the present invention can be more fully integrated into a desired application since they provide a better structural fit. For these reasons, the PV modules of the present invention are well-adapted to be mounted onto existing architectural surfaces (such as corrugated or profiled roofing or façade elements) that are not flat. Moreover, in some cases, the PV modules of the present invention may entirely replace existing architectural elements (such as roof tiles or façade elements), so that the PV modules provide both the PV function and the desired architectural/structural function. More generally, the modules of the present invention are well-suited for use in any location having a non-flat surface.

The profiles of PV modules 100 may correspond to the size and shape of existing materials already used and standardized within the construction and roofing industry, for example 76 mm or 18 mm corrugated roof tiles. In addition, each PV module can be mounted onto (or can replace) one or several standardized architectural units. For example, a single PV module 100 may be produced with a 1 x 2 meter surface size and could be used to cover (or replace) several roofing tiles. With existing PV manufacturing processes, such a module would be able to produce a peak PV power of about 50-300 Watts at about 12 to 300 Volts. Optionally, the size of the module could be increased, e.g., to 2 x 10 meters, to cover an entire roof section or the whole length of a façade. Alternatively, the surface area of a PV module may be reduced to correspond to the size of a single individual roof tile, e.g., 30 x 50 cm.

Mounting of a PV module 100 -- either to or as an architectural element -- may occur in any conventional manner. For example, a module 100 may be fixed to another element or a surface using clips, using screws through mounting holes drilled through the profile, or using any other fastening technique. In some cases, it may be desirable to provide an air gap beneath a profiled PV module to help cool the PV film and improve its efficiency. Multiple PV modules 100 may also be welded or glued together to form a larger sealed section for a roof or façade. A PV module 100 may further be combined with a thermal insulation layer (e.g., polyurethane foam) beneath the module. Such an insulation layer is preferably applied along the entire bottom surface of the profiled PV module, for example by applying the foam to that surface by extrusion. Such an insulation layer may additionally improve and stabilize the mechanical and structural properties of the profiled PV module. In particular, a back-insulated profiled module is particularly advantageous in conjunction with the use of amorphous silicon as a PV material, since the temperature coefficient of the power output by such a module is relatively small.

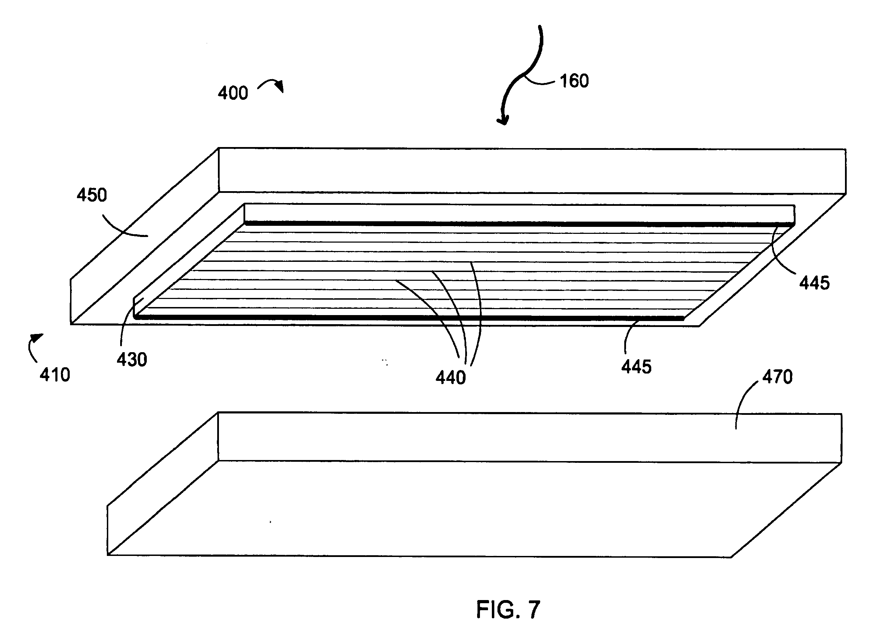

While the invention has been described in conjunction with specific embodiments, it is evident that numerous alternatives, modifications, and variations will be apparent to those skilled in the art in light of the foregoing description. For example, in one possible variation, Fig. 7 illustrates the layers used (prior to bonding and profiling) in a PV module 400. As shown, module 400 includes a PV film 410 including a PV cell structure 430 fabricated on a relatively thick superstrate 450 comprising, for example, PET (polyethylene terephtalate) and a sheet of bottom encapsulant material 470. In this embodiment, superstrate 450 acts as both an insulating base on which PV cell structure 430 is fabricated as well as the top encapsulant layer in the subsequent bonding step. In this manner, superstrate 450 should possess the transparency and UV resistant characteristics previously described for top encapsulant layer 150. It may also be noted that superstrate 450 may have a relatively large thickness so that the resulting PV film 410 is not flexible under ordinary (i.e., naturally occurring) temperatures. Alternatively, the thickness of superstrate 450 may be relatively small but the thickness of the sheet of bottom encapsulant material 470 may be correspondingly increased, in which case PV film 410 may still be flexible. Furthermore, it will be appreciated that, in this embodiment, the base electrode first deposited onto superstrate 450 should comprise a TCO and, if a p-i-n configuration is used for cells in PV cell structure 430, p-type, i-type, and n-types layers are then sequentially deposited above the TCO electrode layer. Finally, although in Fig. 7 the superstrate 450 is shown as having a larger surface area than PV cell structure 430, it may not be practical to fabricate PV film 410 in this manner. If so, to ensure that, the edges of PV cell structure 430 are sufficiently protected and covered by encapsulant material after bonding, a larger bottom encapsulant sheet 470 may be used and/or additional encapsulant material may be added after the PV film 410 and the sheet of bottom encapsulant 470 have been initially bonded together. The resulting bonded stack can then be profiled in the manner described above.

Several modules may be assembled together, after shaping but preferably before mounting on a roof, in order to extend the width and/or the length or the resulting photovoltaic element. Electrical connections between neighboring modules are preferably accomplished without any wire, by overlapping or contacting the busbars 145 in order to provide the desired serial or parallel connections. Assembly of the different modules is however made in such a manner as to guarantee identical or similar sunshine amount on mutually serially connected cells when the assembled photovoltaic element is mounted.

More specifically, in an embodiment where the module is intended for use on or as a corrugated or profiled roofing element, the plane x;z defining the two dimensional profile of the module may extend in an upward direction substantially parallel to the ridge or edge of the roof. In this case, the strips 130 preferably extend along an horizontal direction parallel to this ridge or edge.

If, on the other hand, the plane x; z defining the two dimensional profile extends in an upward direction perpendicular to the ridge or edge of the roofing, the strips 130 preferably extend in an upward direction, perpendicular to said ridge or edge.

The module may also be used asa profiled or corrugated substantially vertical façade element. In this case, if the plane (x; z) defining the two dimensional profile is horizontal when said module is mounted, the strips will preferably extend horizontally. If on the other side the plane isvertical, the strips will preferably extend in an upward direction.

## Claims

1. An electric energy generating module (100) comprising:
an electric energy generating photovoltaic film (110) sealed between a top layer (150) of at least partially transparent encapsulant material and a bottom layer (170) of encapsulant material,
wherein the type and quantity of the encapsulant materials are such that the shape of the module can be altered when at least one of a high temperature or a pressure is applied thereto but wherein the encapsulant materials provide a rigid structure around the electric energy generating film (110) under ordinary temperature and pressure conditions,
wherein the electric energy generating film comprises a plurality of strip-shaped cells (130) electrically connected with one another,
wherein the module is shaped to provide a desired two dimensional profile,
**characterised in that** the longitudinal direction (x1) of each strip-shaped cell (130) extendsin parallel to a plane (x;z) defining said two dimensional profile.

2. The module of claim 1, wherein said striped shaped cells (130) are connected in series to one another.

3. The module of one of the claims 1 or 2, wherein the type and quantity of the encapsulant materials and of the other layers are such that the shape of the module is permanently altered by application of the following steps:
softening of the encapsulant materials by application of a high temperature,
application of a pressure to the module (100) in order to obtain the desired shape,
hardening of the encapsulant materials.

4. The module of claim 3, wherein the type and quantity of the encapsulant materials are such that the shape of the module is altered by the application of a temperature of between 70 and 250°C and a pressure of between 10³ Pa to 10⁵ Pa (0.01 to 1 bar).

5. The module of one of the claims 3 to 4, wherein the type and quantity of the materials used in at least one layer of the module are such that the shape of the module cannot be permanently altered under normal temperature conditions without cracking, even if a pressure is applied temporarily thereto.

6. The module of one of the claims 1 to 5, wherein the electric energy generating film (110) comprises a substrate (120) flexible under ordinary temperature and pressure conditions.

7. The module of claim 6, wherein the substrate (120) of the electric energy generating film (110) comprises at least one of the following materials: polyimide, polyethylene terephtalate (PET), or polyethylene naphthalate (PEN), aluminium, insulator-metal composites or fiber-enforced material.

8. The module of one of the claims 1 to 7, wherein, in accordance with the two dimensional profile of the module, the electric energy generating film (110) within the module (100) is not flat.

9. The module of one of the claims 1 to 8, wherein the electric energy generating film (110) comprises an amorphous silicon semiconductor structure, a microcrystalline silicon, a thin film silicon, a CIS element, a CdTe element and/or a thin film tandem cell.

10. The module of one of the claims 1 to 9, wherein the electric energy generating film (110), the top encapsulant material (150), and the bottom encapsulant material (170) have been bonded together to provide a stack with a flat profile, prior to the module having been shaped to provide a two dimensional profile.

11. The module of one of the claims 1 to 10, wherein the electric energy generating film (110), the top encapsulant material (150), and the bottom encapsulant material (170) have been sealed together in a continuous laminating process, prior to the module having been shaped and cut at the desired length.

12. The module of one of the claims 1 to 11 wherein the module (100) is shaped using an injection molding process and the top and bottom encapsulant materials comprise a resin suitable for injection during said process.

13. The module of one of the claims 1 to 12 wherein the top encapsulant material comprises at least one of the following materials: PE polyethylene (PE), polyethylene terephtalate (PET), polyethylene naphthalate (PEN), polycarbonate (PC), polymethyl methacrylate (PMMA), Ethylene vinyl acetate (EVA), Thermoplastic polyurethane (TPU), Ethylene tetrafluorethylene (ETFE).

14. The module of claim 13 wherein the bottom encapsulant material comprises the same material asthe top encapsulant material.

15. The module of one of the claims 1 to 14, wherein the two dimensional profile of the module (100) corresponds to the non-flat profile of an architectural unit or surface to enable the module to be mounted onto said architectural unit or surface or to replace one or more of said architectural units.

16. The module of claim 15, wherein the two dimensional profile of the module corresponds to the profile of a corrugated or profiled roofing or façade element.

17. The module of claim 16, wherein the two dimensional profile of the module corresponds to the profile of a corrugated or profiled roofing,
wherein said module comprises at least one strip (130) intended to extend along a direction substantially parallel to the ridge or edge of said roofing when said module is mounted,
and wherein said plane (x; z) defining said two dimensional profile extends in an upward direction substantially parallel to said ridge or edge when said module is mounted.

18. The module of claim 16, wherein the two dimensional profile of the module corresponds to the profile of a corrugated or profiled façade element,
wherein said module comprises at least one strip (130) intended to extend along a direction substantially horizontal when said module is mounted,
and wherein said plane (x; z) defining said two dimensional profile extends in direction substantially horizontal when said module is mounted.

19. The module of one of the claims 1 to 15, wherein the two dimensional profile of the module corresponds to the profile of a corrugated or profiled roofing,
wherein said module comprises at least one strip (130) intended to extend in an upward direction when the module is mounted,
and wherein said plane (x; z) defining said two dimensional profile extends in an upward direction substantially perpendicular to said ridge or edge when said module is mounted.

20. The module of claim 16, wherein the two dimensional profile of the module corresponds to the profile of a corrugated or profiled façade element,
wherein said module comprises at least one strip (130) intended to extend along a direction substantially vertical when said module is mounted,
and wherein said plane (x; z) defining said two dimensional profile extends in direction substantially vertical when said module is mounted.

21. The module of one of the claims 1 to 20, wherein the top layer of encapsulant material also comprises a superstrate for the electric energy generating film.

22. The module of one of the claims 1 to 21, further comprising a thermal insulation layer applied to a bottom surface of the module after the module has been shaped.

23. The module of one of the claims 1 to 22, further comprising a three-dimensional texture in said top-encapsulant layer designed so asto improve convergence of light on to PV active portions of the module.

24. A method of fabricating an electric energy generating module (100) comprising:
providing an electric energy generating film (110) comprising a plurality of strip-shaped cells (130) electrically connected with one another, a top layer of encapsulant material (150) and a bottom layer of encapsulant material (170);
applying at least one of a high temperature and a pressure to bond the electric energy generating film, the top layer of encapsulant material and the bottom layer of encapsulant material together as a bonded stack; and
maintaining or applying a high temperature to melt / soften said encapsulant material, and applying a pressure to shape the bonded stack to provide the module with a desired two dimensional profile,
wherein the type and quantity of the encapsulant materials provided are such that the shape of the module can be altered when at least one of a high temperature and a pressure is applied there to but wherein the encapsulant materials (150, 170) provide a rigid structure around the electric energy generating film (110) under ordinary temperature and pressure conditions,
**characterised in that** the longitudinal direction (x1) of each strip-shaped cell extends in parallel to a plane (x;z) defining said two dimensional profile.

25. The method of claim 24 wherein the bonding comprises applying both a high temperature and a pressure.

26. The method of claim 25 wherein the bonding comprises applying a temperature of between 70 and 250°C and a pressure of between 3·10⁴ Pa to 10⁶ Pa (0.3 to 10 bar) and wherein the shaping comprises applying a temperature of between 70 and 250°C and a pressure of between 10³ Pa to 10⁵ Pa (0.01 to 1 bar).

27. The method of one of the claims 24 to 26, wherein the shaping is carried out immediately following the bonding.

28. The method of one of the claims 24 to 27, wherein the shaping is carried out simultaneously with the bonding.

29. The method of one of the claims 24 to 28, wherein the shaping comprises using an injection molding process and the top and bottom encapsulant materials comprise a resin suitable for being injected during said process.

30. The method of one of the claims 24 to 29, said high temperature being sufficient for melting said encapsulant materials without damaging said electric energy generating film (110), said method comprising a step of releasing said temperature for re-hardening the encapsulant materials after shaping.

31. The method of one of the daims24 to 30, further comprising a step of applying a three-dimensional surface texture to said top-encapsulant layer.

## Patentansprüche

1. Ein elektrische Energie erzeugendes Modul (100) umfassend:
einen elektrische Energie erzeugenden photovoltaischen Film (110), der zwischen einer oberen Schicht (150) von mindestens teilweise transparenten Einkapselungsmaterial und einer unteren Schicht (170) des Einkapselungsmaterials eingeschlossen ist,
in welchem die Art und die Qualität der Einkapselungsmaterialien derart sind, dass die Form des Moduls verändert werden kann, wenn mindestens eine hohe Temperatur oder ein Druck daran angewendet wird, aber in welchem die Einkapselungsmaterialien unter normalen Temperatur- und Druckkonditionen eine starre Struktur um den elektrische Energie generierenden Film (110) bereitstellen,
in welchem der elektrische Energie erzeugenden Film eine Vielzahl von in Streifen geformten Zellen (130) umfasst, die elektrisch miteinander verbunden sind,
wobei das Modul geformt ist, um ein gewünschtes zweidimensionales Profil bereitzustellen,
**dadurch gekennzeichnet, dass** die longitudinale Richtung (x1) von jeder in Streifen geformten Zelle (130) sich parallel zu einer Ebene (x;z), die besagtes zweidimensionales Profil definiert, ausdehnt.

2. Das Modul gemäss Anspruch 1, in welchem besagte in Streifen geformte Zellen (130) in Serie miteinander verbunden sind.

3. Das Modul gemäss einem der Ansprüche 1 oder 2, in welchem die Art und Qualität des Einkapselungsmaterials und von den anderen Schichten so sind, dass die Form des Moduls permanent durch die Anwendung der folgenden Schritte verändert wird:
Ausweichen des Einkapselungsmaterials durch Anwendung von einer hohen Temperatur,
Anwendung von einem Druck zu dem Modul (100), um die gewünschte Form zu erhalten,
Aushärten der Einkapselungsmaterialien.

4. Das Modul gemäss Anspruch 3, in welchem die Art und die Qualität der Einkapselungsmaterialien so sind, dass die Form des Moduls durch die Anwendung einer Temperatur zwischen 70 und 250°C und einem Druck zwischen 10³ Pa bis 10⁵ Pa verändert wird.

5. Das Modul gemäss einem der Ansprüche 3 bis 4, in welchem die Art und Qualität der verwendeten Materialien in mindestens einer Schicht des Moduls so sind, dass die Form des Moduls unter normalen Temperaturbedingungen nicht permanent ohne Brechen verändert werden kann, selbst wenn ein Druck zeitweilig daran angewendet wird.

6. Das Modul gemäss einem der Ansprüche 1 bis 5, in welchem der elektrische Energie erzeugende Film (110) ein Substrate (120) umfasst, das unter normalen Temperatur- und Druckbedingungen flexibel ist.

7. Das Modul gemäss Anspruch 6, in welchem das Substrat (120) des elektrische Energie erzeugenden Films mindestens eins der folgenden Materialien Polyimide, Polyethylen Terephtalate (PET) oder Polyethylen Naphthalate (PEN), Aluminium, isolierende Metallzusammensetzungen oder faserverstärkte Materialien umfasst.

8. Das Modul gemäss einem der Ansprüche 1 bis 7, in welchem in Übereinstimmung mit dem zweidimensionalen Profil des Moduls, der elektrische Energie erzeugende Film (110) in dem Modul (100) nicht flach ist.

9. Das Modul gemäss einem der Ansprüche 1 bis 8, in welchem der elektrische Energie erzeugende Film (110) eine amorphe Silikonhalbleiterstruktur, ein mikrokristallines Silikon, ein Dünnfilmsilikon, ein CIS-Element, ein CdTE-Element und/oder eine dünne Filmtandemzelle umfasst.

10. Das Modul gemäss einem der Ansprüche 1 bis 9, in welchem der elektrische Energie erzeugende Film (110), das obere Einkapselungsmaterial (150) und das untere Einkapselungsmaterial (170) zusammengefügt wurden, um einen Stapel mit einem ebenen Profil zu bilden, bevor das Modul geformt wird, um ein zweidimensionales Profil zu bilden.

11. Das Modul gemäss einem der Ansprüche 1 bis 10, in welchem der elektrische Energie erzeugende Film (110), das obere Einkapselungsmaterial (150) und das untere Einkapselungsmaterial (170) in einem kontinuierlichen Laminationsverfahren zusammengefügt wird, bevor das Modul geformt und auf eine gewünschte Länge geschnitten wird.

12. Das Modul gemäss einem der Ansprüche 1 bis 11, in welchem das Modul (100) unter Verwendung eines Gussinjektionsverfahrens geformt ist und die oberen und unteren Einkapselungsmaterien ein Harz umfassen, welches geeignet ist, um während des besagten Verfahrens injiziert zu werden.

13. Das Modul gemäss einem der Ansprüche 1 bis 12, in welchem das obere Einkapselungsmaterial mindestens eins der folgenden Materialien: Polyethylen (PE), Polyethylen Terephtalate (PET), Polyethylen Naphthalate (PEN), Polycarbonate (PC), Polymethyl Methacrylate (PMMA), Ethylen Vinyl Acetate (EVA), Thermoplatic Polyurethane (TPU), Ethylen tetrafluorethylene (ETFE) umfassen.

14. Das Modul gemäss Anspruch 13, in welchem das untere Einkapselungsmaterial das gleiche Material wie das obere Einkapselungsmaterial umfasst.

15. Das Modul gemäss einem der Ansprüche 1 bis 14, in welchem das zweidimensionale Profil des Moduls (100) zu einem nicht ebenen Profil einer architektonischen Einheit oder Oberfläche gehört, um das Modul auf besagte architektonische Einheit oder Oberfläche zu montieren oder einen oder mehrere von den architektonischen Einheiten zu ersetzen.

16. Das Modul gemäss Anspruch 15, in welchem das zweidimensionale Profil des Moduls zu einem Profil eines gewellten oder profilierten Dachs oder Fassadenelement korrespondiert.

17. Das Modul gemäss Anspruch 16, in welchem das zweidimensionale Profil des Moduls zu dem Profil eines gewellten oder profilierten Dachs gehört,
in welchem besagtes Modul mindestens einen Streifen (130) umfasst, dazu beabsichtigt, um sich entlang einer Richtung im Wesentlichen parallel zu dem Grat oder eine Kante des besagten Dachs auszudehnen, wenn besagtes Modul montiert ist,
und wobei sich besagte Ebene (x;z), die besagtes zweidimensionales Profil definiert, in einer nach oben gerichteten Richtung im Wesentlichen parallel zu besagtem Grat oder Kante ausdehnt, wenn besagtes Modul montiert ist.

18. Das Modul gemäss Anspruch 16, in welchem das zweidimensionale Profil des Moduls zu dem Profil eines gewellten oder profilierten Fassadenelements gehört,
in welchem besagtes Modul mindestens einen Streifen (130) beabsichtigt, um sich in einer im Wesentlichen horizontalen Richtung auszudehnen, wenn das Modul montiert ist,
und in welchem sich besagte Ebene (x;z), die besagtes zweidimensionales Profil definiert, in einer im Wesentlichen horizontalen Richtung ausdehnt, wenn das Modul montiert ist.

19. Das Modul gemäss einem der Ansprüche 1 bis 15, in welchem das zweidimensionale Profil des Moduls dem Profil einer gewellten oder profilierten Fassade eines gewellten oder profilierten Dachs entspricht,
in welchem besagtes Modul mindestens einen Streifen (130) umfasst, beabsichtigt, um sich in einer nach oben gerichteten Richtung auszudehnen, die im Wesentlichen senkrecht zu besagtem Grat oder Kante ist, wenn besagtes Modul montiert ist,
und in welchem sich besagte Ebene (x;z), die besagtes zweidimensionales Profil definiert, in einer nach oben gerichteten Richtung im Wesentlichen senkrecht zu besagtem Grat oder Kante ausdehnt, wenn das Modul montiert ist.

20. Das Modul gemäss Anspruch 16, in welchem das zweidimensionale Profil des Moduls zu dem Profil eines gewellten oder profilierten Fassadenelements gehört,
in welchem besagtes Modul mindestens einen Streifen (130) umfasst, beabsichtigt, um sich entlang einer Richtung im Wesentlichen vertikal auszudehnen, wenn besagtes Modul montiert ist,
und in welchem sich besagte Ebene (x;z), die besagtes zweidimensionales Profil definiert, in im Wesentlichen vertikaler Richtung ausdehnt, wenn besagtes Modul montiert ist.

21. Das Modul gemäss einem der Ansprüche 1 bis 20, in welchem die obere Schicht des Einkapselungsmaterials auch einen Überzug für den elektrische Energie erzeugenden Film umfasst.

22. Das Modul gemäss einem der Ansprüche 1 bis 21, weiter umfassend eine thermische Isolationsschicht, angebracht auf der unteren Oberfläche des Moduls, nachdem das Modul geformt wurde.

23. Das Modul gemäss einem der Ansprüche 1 bis 22, weiter umfassend eine dreidimensionale Struktur in besagter oberen Einkapselungsschicht, die so konzipiert ist, um die Konvergenz von Licht auf die aktiven PV-Teile des Moduls zu verbessern.

24. Ein Verfahren, um ein elektrische Energie erzeugendes Modul (100) herzustellen, umfassend:
Bereitstellen eines Energie erzeugenden Films (110), welcher eine Vielzahl von in Streifen geformten Zellen (130) umfasst, die elektrisch miteinander verbunden sind, einer oberen Schicht eines Einkapselungsmaterials (150) und einer unteren Schicht eines Einkapselungsmaterials (170);
Anwendung von mindestens einer hohen Temperatur und einem Druck, um den elektrische Energie erzeugenden Film, die obere Schicht des Einkapslungsmaterials und die untere Schicht des Einkapslungsmaterials miteinander als ein verbundenen Stapel zu verbinden; und
Aufrechterhalten oder Anwendung einer hohen Temperatur, um besagtes Einkapselungsmaterial zu schmelzen/aufzuweichen, und die Anwendung eines Drucks, um den verbundenen Stapel zu formen, um ein Modul mit einem gewünschten zweidimensionalen Profil zu schaffen,
in welchem die Art und die Qualität der bereit gestellten Einkapselungsmaterialien derart sind, dass die Form des Moduls verändert werden kann, wenn mindestens eine von einer hohen Temperatur und ein Druck daran angewendet wird, aber in welchem die Einkapselungsmaterialien (150, 170) unter normalen Temperatur und Druckkonditionen eine starre Struktur um den elektrische Energie erzeugenden Film (110) bereitstellen,
**dadurch gekennzeichnet, dass** die longitudinale Richtung (x1) von jeder in Streifen geformten Zelle sich parallel zu einer Ebene (x;z), die besagtes zweidimensionales Profil definiert, ausdehnt.

25. Das Verfahren gemäss Anspruch 24, in welchem das Verbinden die Anwendung von sowohl einer hohen Temperatur und als auch einem Druck umfasst.

26. Das Verfahren gemäss Anspruch 25, in welchem das Verbinden die Anwendung einer Temperatur zwischen 70 und 250°C und einem Druck 3 * 10⁴ Pa bis 10⁶ Pa umfasst und in welchem das Formen die Anwendung einer Temperatur zwischen 70 und 250°C und einem Druck 10³ Pa bis 10⁵ Pa umfasst.

27. Das Verfahren gemäss einem der Ansprüche 24 bis 26, in welchem das Formen unmittelbar nach dem Verbinden ausgeführt wird.

28. Das Verfahren gemäss einem der Ansprüche 24 bis 27, in welchem das Formen gleichzeitig mit dem Verbinden ausgeführt wird.

29. Das Verfahren gemäss einem der Ansprüche 24 bis 28, in welchem das Formen den Gebrauch eines Gussinjektionsverfahrens umfasst und die oberen und unteren Einkapselungsmaterialien ein Harz umfassen, welches geeignet ist, um während des besagten Verfahrens injiziert zu werden.

30. Das Verfahren gemäss einem der Ansprüche 24 bis 29, wobei besagte hohe Temperatur ausreichend ist, um besagte Einkapselungsmaterialien zu schmelzen, ohne besagten Energie erzeugenden Film (110) zu beschädigen, wobei besagtes Verfahren einen Schritt zur Entlastung der Temperatur umfasst, um die Einkapselungsmaterialien nach dem Formen wiederzuerhärten.

31. Das Verfahren gemäss einem der Ansprüche 24 bis 30, weiter umfassend einem Schritt der Anwendung einer dreidimensionalen Oberflächenstruktur zu besagter oberer Einkapselungsschicht.

## Revendications

1. Un module générateur d'énergie électrique (100) comprenant:
un film photovoltaïque (110) générateur d'énergie électrique scellé entre une couche supérieure (150) de matériau encapsulant au moins partiellement transparent et une couche inférieure (170) de matériau encapsulant,
le type et la quantité de matériaux encapsulants étant tels que la forme du module peut être modifiée lorsqu'au moins une haute température ou une pression lui est appliquée, mais les matériaux encapsulants fournissant une structure rigide autour du film générateur d'énergie électrique (110) sous des conditions de température et de pressions ordinaires,
le film générateur d'énergie électrique comprenant une pluralité de cellules (130) en forme de bande connectées électriquement les unes aux autres,
le module étant façonné pour fournir un profil bidimensionnel souhaité,
**caractérisé en ce que**
la direction longitudinale (x1) de chaque cellule en forme de bande (130) s'étend parallèlement à un plan (x,z) en définissant ledit profil bidimensionnel.

2. Le module de la revendication 1, dans lequel les cellules en forme de bande (130) sont reliées les unes aux autres en série.

3. Le module de l'une des revendications 1 ou 2, le type et la quantité de matériaux encapsulants et des autres couches étant tels que la forme du module est modifiée de manière permanente par l'application des étapes suivantes:
ramollissement des matériaux encapsulants par application d'une haute température,
application d'une pression sur le module (100) afin d'obtenir la forme désirée,
durcissement des matériaux encapsulants.

4. Le module de la revendication 3, dans lequel le type et la quantité de matériaux encapsulants sont tels que la forme du module est modifiée par application d'une température entre 70 et 250 degrés Celsius et une pression entre 10³ et 10⁵ Pa.

5. Le module selon l'une des revendications 3 à 4, dans lequel le type et la quantité de matériaux utilisés dans au moins une couche du module sont tels que la forme du module ne peut pas être modifiée de manière permanente sous des conditions de températures normales sans craquement, même si une pression lui est appliquée de manière temporaire.

6. Le module selon l'une des revendications 1 à 5, dans lequel le film générateur d'énergie électrique (110) comprend un substrat (120) flexible sous des conditions de température et de pression ordinaires.

7. Le module de la revendication 6, dans lequel le substrat (120) du film générateur d'énergie électrique (110) comprend au moins un des matériaux suivants: polyimide, polyéthylène téréphtalate (PET) ou polyéthylène néphtalate (PEN), aluminium, composites en métal isolant ou matériaux renforcés par des fibres.

8. Le module selon l'une des revendications 1 à 7, dans lequel, conformément au profil bidimensionnel du module, le film générateur d'énergie électrique (110) à l'intérieur du module (100) n'est pas plat.

9. Le module selon l'une des revendications 1 à 8, dans lequel le film générateur d'énergie électrique (110) comprend une structure semiconductrice amorphe en silicium, un silicium microcristallin, un silicium couche mince, un élément CIS, un élément CdTe et/ou une cellule tandem couche mince.

10. Le module selon l'une des revendications 1 à 9, dans lequel le film générateur d'énergie électrique (110), le matériel encapsulant supérieur (150) et le matériel encapsulant inférieur (170) ont été assemblés pour former une pile avec un profil plat avant que le module n'ait été façonné pour avoir un profil bidimensionnel.

11. Le module selon l'une des revendications 1 à 10, dans lequel le film générateur d'énergie électrique (110), le matériel encapsulant supérieur (150) et le matériel encapsulant inférieur (170) ont été scellés ensemble au cours d'un processus de laminage continu avant que le module n'ait été façonné et coupé à la longueur désirée.

12. Le module selon l'une des revendications 1 à 11, dans lequel le module (100) est façonné en utilisant un processus de moulage à injection et les matériaux encapsulants supérieurs et inférieurs comprennent une résine injectable lors de ce processus.

13. Le module selon l'une des revendications 1 à 12, dans lequel le matériel encapsulant supérieur comprend au moins un des matériaux suivants: du polyéthylène (PE), du polyéthylène téréphtalate (PET), polyéthylène naphtalate (PEN), du polycarbonate (PC), du polyméthyl méthacrylate (PMMA), de l'acétate de vinyle éthylène (EVA), du polyuréthane thermoplastique (TPU), du tétrafluoréthylène d'éthylène (ETFE).

14. Le module de la revendication 13, dans lequel le matériau encapsulant inférieur comprend le même matériel que le matériel encapsulant supérieur.

15. Le module selon l'une des revendications 1 à 14, dans lequel les deux profils bidimensionnels du module (100) correspondent au profil non plat d'une unité ou surface architecturale pour permettre au module d'être monté sur ladite unité ou surface architecturale ou pour remplacer une ou plusieurs desdites unités architecturales.

16. Le module de la revendication 15, dans lequel le profil bidimensionnel du module correspond au profil d'une couverture ondulée ou profilée ou élément de façade.

17. Le module de la revendication 16, dans lequel le profil bidimensionnel du module correspond au profil d'une couverture ondulée ou profilée,
ledit module comprenant au moins une bande (130) destinée à s'étendre le long d'une direction substantiellement parallèle à la crête ou à l'arête de ladite couverture lorsque ledit module est monté,
et ledit plan (x;z) définissant ledit profil bidimensionnel s'étendant dans une direction vers le haut substantiellement parallèle à ladite crête ou arête lorsque ledit module est monté.

18. Le module de la revendication 16, dans lequel le profil bidimensionnel du module correspond au profil d'un élément de façade ondulé ou profilé,
ledit module comprenant au moins une bande (130) destinée à s'étendre le long d'une direction substantiellement horizontale lorsque ledit module est monté,
et ledit plan (x;z) définissant ledit profil bidimensionnel s'étendant dans une direction substantiellement horizontale lorsque ledit module est monté.

19. Le module selon l'une des revendications 1 à 15, dans lequel le profil bidimensionnel du module correspond au profil d'un élément de façade ondulé ou profilé,
ledit module comprenant au moins une bande (130) destinée à s'étendre dans une direction vers le haut lorsque ledit module est monté,
et ledit plan (x;z) définissant ledit profil bidimensionnel s'étendant dans une direction vers le haut substantiellement perpendiculaire à ladite crête ou arête lorsque ledit module est monté.

20. Le module de la revendication 16, dans lequel le profil bidimensionnel du module correspond au profil d'un élément de façade ondulé ou profilé,
ledit module comprenant au moins une bande (130) destinée à s'étendre dans une direction substantiellement verticale lorsque ledit module est monté,
et ledit plan (x;z) définissant ledit profil bidimensionnel s'étendant dans une direction substantiellement verticale lorsque ledit module est monté.

21. Le module selon l'une des revendications 1 à 20, dans lequel la couche supérieure de matériel encapsulant comprend également un revêtement pour le film générateur d'énergie électrique.

22. Le module selon l'une des revendications 1 à 21, comprenant en outre une couche d'isolation thermique appliquée à la surface inférieure du module après que le module ait été façonné.

23. Le module selon l'une des revendications 1 à 22, comprenant en outre une texture en trois dimensions dans ladite couche d'encapsulation supérieure conçue pour améliorer la convergence de la lumière sur les portions actives PV du module.

24. Une méthode de fabrication d'un module générateur d'énergie électrique (100) comprenant:
de fournir un film générateur d'énergie électrique (110) comprenant une pluralité de cellules en forme de bande (130) connectées électriquement les unes aux autres, une couche supérieure de matériel encapsulant (150) et une couche inférieure de matériau encapsulant (170);
d'appliquer au moins une haute température ou pression pour assembler le film générateur d'énergie électrique, la couche supérieure de matériau encapsulant et la couche inférieure de matériau encapsulant ensemble en tant que pile agglomérée; et
de maintenir ou d'appliquer une haute température pour faire fondre ou ramollir les matériaux encapsulants, et d'appliquer une pression pour façonner la pile agglomérée pour donner au moule le profil bidimensionnel désiré,
le type et la quantité de matériaux encapsulants fournis étant tels que la forme du module peut être modifiée lorsqu'au moins une haute température ou une haute pression lui sont appliquées, mais les matériaux encapsulants (150,170) fournissant une structure rigide autour du film générateur d'énergie électrique (110) sous des conditions normales de température et de pression,
**caractérisée en ce que**
la direction longitudinale (x1) de chaque cellule en forme de bande s'étende parallèlement à un plan (x,z) définissant ledit profil bidimensionnel.

25. La méthode de la revendication 24, dans laquelle l'assemblage comprend l'application à la fois d'une haute température et d'une pression.

26. La méthode de la revendication 25, dans laquelle l'assemblage comprend l'application d'une haute température entre 70 et 250°C et d'une pression de 3·10⁴ Pa à 10⁶ Pa et dans laquelle le façonnage de la forme comprend l'application d'une température entre 70 et 250°C et une pression entre 10³ Pa et 10⁵ Pa.

27. La méthode selon l'une des revendications 24 à 26, dans laquelle le façonnage de la forme est effectué immédiatement après l'assemblage.

28. La méthode selon l'une des revendications 24 à 27, dans laquelle le façonnage de la forme et l'assemblage sont effectués simultanément.

29. La méthode selon l'une des revendications 24 à 28, dans laquelle le façonnage de la forme comprend un processus de moulage par injection et les matériaux encapsulants inférieurs et supérieurs comprennent une résine injectable lors dudit processus.

30. La méthode selon l'une des revendications 24 à 29, ladite haute température étant suffisante pour faire fondre lesdits matériaux encapsulants sans endommager ledit film générateur d'énergie électrique (110), ladite méthode comprenant une étape d'allègement de ladite température pour resolidifier les matériaux encapsulants après le façonnage de la forme.

31. La méthode selon l'une des revendications 24 à 30, comprenant en outre une étape d'application d'une texture de surface à trois dimensions à ladite couche encapsulante supérieure.
